(19) Europäisches Patentamt
European Patent Office
Office européen des brevets

(11) Veröffentlichungsnummer: **0 177 862**
**A2**

(12) # EUROPÄISCHE PATENTANMELDUNG

(21) Anmeldenummer: **85112316.6**

(22) Anmeldetag: **28.09.85**

(51) Int. Cl.[4]: **H 05 K 1/00**, C 23 C 18/00

(30) Priorität: **09.10.84 DE 3436971**

(43) Veröffentlichungstag der Anmeldung: **16.04.86 Patentblatt 86/16**

(84) Benannte Vertragsstaaten: **BE CH DE FR GB IT LI NL SE**

(71) Anmelder: **BAYER AG, Konzernverwaltung RP Patentabteilung, D-5090 Leverkusen 1 Bayerwerk (DE)**

(72) Erfinder: **Sirinyan, Kirkor, Dr., Humperdinckstrasse 12, D-5060 Bergisch-Gladbach (DE)**
Erfinder: **Wolf, Gerhard Dieter, Dr., Wilhelm-Busch-Strasse 29, D-4047 Dormagen (DE)**
Erfinder: **von Gizycki, Ulrich, dr., Wiembachallee 24, D-5090 Leverkusen 3 (DE)**
Erfinder: **Merten, Rudolf, Dr., Berta-von-Suttner-Strasse 55, D-5090 Leverkusen 1 (DE)**

(54) **Halbzeuge zur Herstellung von Leiterplatten.**

(57) Für die stromlose Metallisierung von Basisträgern zur Herstellung von Leiterplatten eignen sich hervorragend solche Trägermaterialien, auf denen Komplexverbindungen aufgebaut sind, in denen die Liganden und die zu komplexierenden Ionen eine «Wirt-Gast-Wechselbeziehung» eingegangen sind. Beispiele für derartige Aktivatorverbindungen sind Komplexe von Kronenethern, Cryptanden u. dgl. Die resultierenden Leiterplatten zeichnen sich durch hohe Haftfestigkeiten ihrer Metallauflagen aus.

EP 0 177 862 A2

BAYER AKTIENGESELLSCHAFT 5090 Leverkusen, Bayerwerk

Konzernverwaltung RP K/by-c
Patentabteilung

## Halbzeuge zur Herstellung von Leiterplatten

Gegenstand der Erfindung sind Halbzeuge zur Herstellung von Leiterplatten.

Es ist allgemein bekannt, daß die Abscheidung von haftfesten Metallauflagen auf den üblichen Isolierbasismaterialien eine aufwendige Vorbehandlung erfordert. So müssen beispielsweise die Basisplatten zur Herstellung von Leiterplatten aus glasmattenverstärkten Epoxidharzen oder papierverstärkten Phenolharzen zunächst mit einer Haftvermittlerschicht versehen und anschließend mit oxidierenden Flüssigkeit, vorzugsweise Chromschwefelsäure, behandelt werden, bevor die so präparierten Platten mit ionischen oder kolloidalen Edelmetallösungen aktiviert, maskiert und in handelsüblichen Metallisierungsbädern metallisiert werden.

Abgesehen von der Vielstufigkeit dieser Methoden weist diese Technik den Nachteil auf, daß eingeschleppte Chromionen die Bäder irreversibel vergiften und daß die erhaltenen Leiterplatten unbefriedigende elektrische Eigenschaften zeigen.

Es ist daher bereits vorgeschlagen worden, die nichtleitenden Oberflächen von Substraten, beispielsweise Basisträger von Leiterplatten, ohne oxidative Vorbehandlung mit einer Lösung oder einem Lack einer Edelmetallaminkomplexverbindung bzw. des Palladiumchlorids für die anschließende chemische Metallisierung zu aktivieren (vgl. z.B. DE-A 1 696 603 und DE-A 2 116 389, entsprechend US-A 3 560 257 bzw. US-A 4 248 632).

Diese an sich materialschonenden Aktivierungsverfahren konnten sich jedoch bislang in der Praxis nicht durchsetzen, da sie verhältnismäßig große Edelmetallmengen benötigen und die in der Elektronikindustrie geforderten hohen Abzugsfestigkeiten der Metallauflagen nicht erreichen. Aus diesem Grunde wird zumindest in der erstgenannten Patentpublikation eine zusätzliche Oberflächenbehandlung mit Ätzmitteln empfohlen (vgl. Spalte 6, Zeile 48).

Es wurde nun gefunden, daß man diese Nachteile vermeiden und auf einfache Weise, d.h. ohne Ätzung und ohne Haftvermittlerschicht, zu Halbzeugen zur Herstellung von Leiterplatten gelangen kann, wenn man die Basisplatten mit einem Aktivatorsystem behandelt, das eine Metallkomplexverbindung enthält, worin die (selektiven) Liganden und die zu komplexierenden Ionen oder Moleküle in einer sogenannten "Wirts/Gast-Wechselbeziehung" stehen.

Gewünschtenfalls kann man auf den so aktivierten Platten naßchemisch-stromlos oder kombiniert naßchemisch-stromlos/galvanisch eine elektrisch leitfähige Metallauflage mit einer Schichtdicke von 0,1 - 10 µm aufbringen.

Die auf diese Weise aktivierten und dann gegebenenfalls metallisierten Basisplatten, die sogenannten Halbzeuge, können in üblicher Weise nach Volladditiv- oder Semiadditivtechnik zu Leiterplatten (Platinen) verarbeitet werden.

Gegenüber dem bekannten Substraktiv-Verfahren, bei dem bis zu 70 µm starke Metallauflagen partiell mit Hilfe von Ätzlösungen herausgelöst werden müssen, weist das erfindungsgemäße Verfahren bei der Durchführung von Semiadditivtechnik den Vorteil auf, daß man Metallschichten mit einer Dicke von nur maximal 10 µm, vorzugsweise 0,1 bis 7,5 µm bzw. - besonders bevorzugt 0,1 bis 5,0 bzw. 0,1 bis 2,0 µm - herausätzen muß, was eine beträchtliche Materialersparnis zur Folge hat.

Im Vergleich zu ebenfalls bekannten "Dünnschichtmethoden" zur Herstellung von Leiterplatten, die durch das Auflaminieren von galvanisch hergestellten Dünnschichtauflagen oder durch das chemische Abscheiden von Metallen mit Hilfe einer kautschukhaltigen Haftvermittlerauflage charakterisiert sind, zeichnet sich das neue Verfahren durch einen geringeren Arbeitsaufwand sowie verbesserte mechanische, thermische und elektrische Eigenschaften des polymeren Basismaterials aus.

Als selektive Komplexliganden kommen cyclische oder acyclische Verbindungen in Frage, die wegen ihrer chemischen und/oder physikalischen Beschaffenheit ein Wirtsmolekül sind oder in Gegenwart von zu komplexierenden ionogenen oder neutralen Verbindungen die zur Komplex- bzw. Adduktbildung erforderliche Form annehmen, wobei die polaren Bereiche in Gegenwart des zu komplexierenden Mediums zu diesem hin ausgerichtet werden.

Bekanntlich ist die Selektivität des Wirtsmoleküls gegenüber dem zu komplexierenden Gast-Ion bzw. -Molekül von dessen Ringgröße, sterischem Aufbau bzw. chemischer Beschaffenheit (ob polar oder hydrophob) abhängig. In der Literatur sind zahlreiche selektive Wirtsmoleküle, die mit den Alkali- oder Erdalkalikationen wie $Li^+$, $Na^+$, $K^+$, $Ca^{2+}$ oder $NH_4^+$ /vgl. E. Weber, "Kontakte" (Darmstadt) 1, (1984) und J.G. Schindler, "Bioelektrochemische Membranelektroden" S. 77 - 104, Walter de Gruyter Verlag, Berlin/New York (1983)/ oder mit Schwermetallionen wie $Co^{2+}$ , $Ni^{2+}$, $Fe^{3+}$, $Cd^{2+}$ und $Ag^+$ sowie mit Anionen wie $Cl^-$ und $SO_4^{2-}$ /vgl. vorstehend zitierte Arbeit von J.G. Schindler, S. 104 - 112/ sowie mit den neutralen Liganden bzw. Verbindungen einen selektiven Gast-Wirtskomplex bilden können, beschrieben worden.

Zur Durchführung des erfindungsgemäß neuen Verfahrens eignen sich alle Wirtskomplexliganden, die in ihrer Kette Heteroatome (O, N und S) enthalten. Gut geeignet sind Kronenether, Cryptanden und Podanden oder deren

Derivate sowie cyclische Peptide; weiterhin tetrahydrofuranhaltige, esterverknüpfte Makrolide und analoge Verbindungen auf der Basis von Heteroatomen wie S und N, die beispielsweise in biologischen Systemen als Transportregulatoren bekannt sind.

Eine Definition der Begriffe "Kronenether", "Cryptande" und "Podanden" kann den Übersichtsarbeiten F. Vögtle, "Kontakte" (Darmstadt) (1977) und (1978), E. Weber, "Kontakte" (Darmstadt) (1984) sowie Vögtle "Chemikerzeitung" 97, 600 - 610 (1973) entnommen werden.

Zur Durchführung des erfindungsgemäßen Verfahrens werden substituierte bzw. unsubstituierte Wirtsliganden auf der Basis von cyclischen oder acyclischen Kronenethern, die in ihrem Ringsystem noch zusätzlich Heteroatome wie N und S enthalten können, besonders bevorzugt eingesetzt. Solche Verbindungen sind in DE-A 2 842 862 bzw. EP-A 10 615 beschrieben und entsprechen z.B. den Formeln

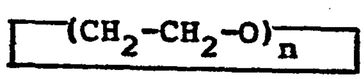

(n = 4-10) (I)

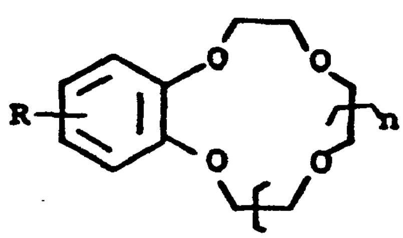

(II)

n = 0-4

R = Alkyl, Aryl, Halogen u.a.

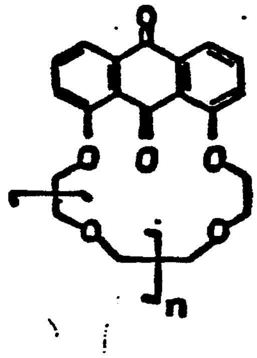

(III)

n = 0-4

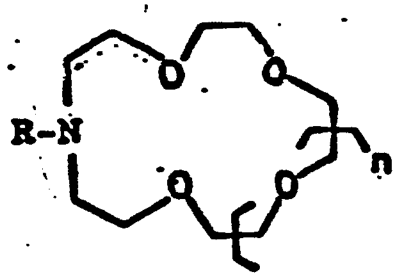

(IV)

n = 0-4

R = Alkyl oder Aryl; z.B. Methyl, Ethyl, Phenyl, Biphenyl, Phenylazophenyl u.a.
Bevorzugt sind die vorstehend genannten cyclischen Verbindungen.

Eine andere Variante der Durchführung des erfindungsgemäßen Verfahrens besteht darin, daß man die erwähnten Wirtsmoleküle in polymeren oder oligomeren Verbindungen kovalent einbaut und sie dann mit den gewünschten Aktivierungsmedien komplexiert. Solche oligomere oder polymere Systeme sind bekannt und werden beispielsweise in "Novel Polyurethanes with Makroheterocyclic (Crown-Ether)

Structures in the Polymer Backbone", J.E. Herweh, J. of Polymer Science: Polymer Chemistry Edition, Vol. 21, 3101 (1983) beschrieben.

Der anorganische Teil der Wirt/Gast-Molekeln wird vorzugsweise

1) aus Verbindungen der Formel

$$Me^{n+}\ E^{m+}\ Hal^{-}_{z}$$

worin Me für Wasserstoff-, Alkali- oder Erdalkaliatome bzw. Schwermetallatome (Fe, Co, Ni oder Cu) oder für $NH_4$, Hal für Halogen (vorzugsweise Cl und Br) und E für ein Edelmetallatom der 1. oder 8. Nebengruppe des Periodensystems, (vorzugsweise Pt, Pd und Au) mit der Wertigkeit m und der Koordinationszahl z steht, wobei z-m=n ist, oder

2) aus den Kationen, der besagten Elemente vorzugsweise $Ag^{+}$, $Cu^{2+}$ und $Cu^{+}$ oder vorzugsweise

3) aus nichtkomplexen Salzen dieser Elemente der Formel

$$E^{m+}\ Hal^{-}_{p}\quad (p=m)$$

oder

4) aus üblichen Kolloidal-Systemen dieser Edelmetalle gebildet.

Bevorzugt anzuwendende Edelmetallverbindungen sind solche der Formel $H_2PdCl_4$, $Na_2(PdCl_2Br_2)$, $Na_2PdCl_4$, $CaPdCl_4$, $Na_4(PtCl_6)$, $AgNO_3$, $HAuCl_4$, $CuCl_2$ und CuCl. Bevorzugt sind die Pd-Verbindungen.

Geeignete kolloidale Edelmetallsysteme leiten sich vor allem von den Metallen Pd, Pt, Au und Ag ab und sind beispielsweise in "Kunststoffgalvanisierung" von R. Weiner, Eugen G. Leuze Verlag, Saulgau/Württ. (1973), Seiten 180 - 209, beschrieben.

Für den im Punkt 1) angegebenen Fall nimmt der elektrisch neutrale Ligand an der Phasengrenze das Kation $M^{n+}$ in seinen endohydrophilen Hohlraum auf und transportiert es in die organische Lösungsmittelphase, wobei durch das entstandene Potentialgefälle auch der Teil $E^{m+}\ Hal_z^-$ in die gewünschte Lösungsmittelphase mittransportiert wird. Dieses Phänomen ist grundsätzlich auch für die Systeme, die in Punkten 2), 3) und 4) aufgeführt werden, relevant.

Die Herstellung der Aktivierungslösung kann durch Lösen des Wirtsmoleküls in einem geeigneten aprotischen Lösemittel mit Siedepunkten bei 80°C wie Perchlorethylen, 1,1,1-Trichlorethan, $CH_2Cl_2$, Petrolether oder Chloroform und Zugabe des Edelmetallsystems nach dem schon erwähnten Prinzip erfolgen.

Eine andere Möglichkeit zur Herstellung der erfindungsgemäß zu verwendenden Aktivierungssysteme ist, daß man die besagten Edelmetalle in einer wäßrigen Phase vorlegt und sie wiederum nach dem erwähnten Prinzip in eine organische Phase, die die komplexbildungsfähige Wirtsmoleküle enthalten, diffundieren bzw. komplexieren läßt, organische Phase von der wäßrigen trennt, sie gegebenenfalls neutralwäscht, durch Umkristallisation oder Eindampfen von dem Lösungsmittel befreit und dann in einem gewünschten flüssigen Medium für die Aktivierung einsetzt.

Obwohl solche Systeme in protischen und aprotischen Lösemitteln unter in der Technik von Kunststoffgalvanisierung üblichen Bedingungen unbegrenzt lagerstabil sind, weisen sie überraschenderweise eine gute Aktivierungseigenschaft für die stromlose chemische Metallisierung auf.

Die Aktivatoren können in Konzentrationsbereichen von 0,001 g/l (bezogen auf das Edelmetall) bis hin zur jeweiligen Löslichkeitgrenze eingesetzt werden. Vorzugsweise arbeitet man mit 0,1 bis 3,0 g/l dieser Substanzen.

Dank ihrer hohen Lagerungsstabilität (keine Eintrübung der Lösungen - z.T. nach wochenlanger Lagerung) und ihrer starken Sorption im ultravioletten und/oder sichtbaren Spektralbereich, eignen sie sich hervorragend für die kontinuierliche Konzentrationsüberwachung mit einem Fotometer.

Im übrigen können die Sorptionseigenschaften der erfindungsgemäß zu verwendenden Komplexverbindungen durch Einführung spezieller Substituenten (insbesondere $NO_2$, $-\overset{+}{N}R_3$, $-SO_3H$ und -CN) noch erhöht werden.

Der Einfluß von elektronenanziehenden bzw. elektronenschiebenden Substituenten auf die Lichtabsorptionseigenschaften von Kohlenstoffmolekeln ist bekannt und kann beispielsweise aus D.H. Williams und J. Flemming "Spektroskopische Methoden in der organischen Chemie", Georg Thieme Verlag Stuttgart (1971) entnommen werden.

Zur Erhöhung der Abzugsfestigkeit der Aktivator- bzw. Metallauflage können die besagten Wirtsmoleküle zusätzlich mit einer weiteren funktionellen Gruppe versehen werden.

In bestimmten Fällen wird mit der weiteren funktionellen Gruppe eine sehr gute Haftfestigkeit der Substratoberfläche erreicht, wobei diese Haftfestigkeit auf eine chemische Reaktion mit der Substratoberlfäche oder auf eine Ad- bzw. Absorption zurückgehen kann.

Besonders geeignet für eine chemische Verankerung des Aktivators an der Substratoberfläche sind funktionelle Gruppen wie Carbonsäuregruppen, Carbonsäurehalogenidgruppen, Carbonsäureanhydridgruppen, Carbonestergruppen, Carbonamid- und Carbonimidgruppen, Aldehyd- und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige, heterocyclische Reste, wie Chlortriazinyl-, -pyrazinyl-, -pyrimidinyl- oder -chinoxalinylgruppen, aktivierte Doppelbindungen, wie bei Vinylsulfonsäure- oder Acrylsäurederivaten, Aminogruppen, Hydroxylgruppen, Isocyanatgruppen, Olefingruppen und Acetylengruppen sowie Mercaptogruppen und Epoxidgruppen, ferner höherkettige Alkyl- oder Alkenylreste ab $C_8$, insbesondere Olein-, Linolein-, Stearin- oder Palmitingruppen.

Wenn keine Verankerung durch eine chemische Reaktion stattfindet, kann die Haftfestigkeit auch durch Absorption der organometallischen Aktivatoren an der Substratoberfläche bewirkt werden, wobei als Ursachen für die Absorption z.B. Wasserstoffbrückenbindungen oder van der Waalssche-Kräfte infrage kommen.

Es ist zweckmäßig, die die Adsorption hervorrufenden funktionellen Gruppen auf das jeweilige Substrat abzustimmen. So verbessern z.B. langkettige Alkyl- oder Alkenyl-Gruppen im Aktivatormolekül die Haftfestigkeit auf Substraten aus Polyethylen oder Polypropylen. Zur Metallisierung von Gegenständen auf Polyamid- oder Polyesterbasis sind dagegen Aktivatoren mit beispielsweise zusätzlichen Carbonyl- oder Sulfongruppen besonders günstig.

Besonders geeignet für eine Verankerung des Aktivators an der Substratoberfläche durch Adsorption sind funktionelle Gruppen wie Carbonsäuregruppen, Carbonsäureanhydridgruppen.

Bei der praktischen Durchführung des neuen Verfahrens geht man im allgemeinen so vor, daß man die zu metallisierenden Basisträger mit einer Lösung des selektiven Metallkomplexes in einem geeigneten organischen Lösungsmittel benetzt, das Lösungsmittel entfernt und gegebenenfalls mit einem geeigneten Reduktionsmittel sensibilisiert. Danach kann der so vorbehandelte Träger in einem üblichen Metallisierungsbad metallisiert werden.

Geeignete Lösungsmittel sind außer den obengenannten Perchlorethylen, 1,1,1-Trichlorethan, $CH_2Cl_2$, n-Hexan, Petrolether, Cyclohexanon, Alkohole wie n-Butanol, tert-Butanol, Isopropanol, Ketone wie Methylethylketon, Aldehyde wie n-Butanal-1, sowie DMF und DMSO.

Wenn die organometallische Verbindung Liganden enthält, die eine chemische Fixierung auf der Substratoberfläche ermöglichen, kann eine Aktivierung auch aus wäßriger Phase möglich sein.

Als Reduktionsmittel für die Sensibilisierung eignen sich Aminoborane, Alkalihypophosphite, Alkaliborhydride, Hydrazinhydrat und Formalin. Das Benetzen der Substrate kann durch Besprühen, Bedrucken, Tränken oder Imprägnieren erfolgen.

Um die Haftung der Metallauflage an der Trägeroberfläche zu erhöhen, werden solche Lösungsmittel oder Lösungsmittelgemische, die zu einer geringen Anlösung oder Anquellung

der zu metallisierenden Kunststoffoberfläche führen, zur Durchführung des erfindungsgemäßen Verfahrens besonders bevorzugt eingesetzt.

Zur Durchführung des Verfahrens sind aprotische Lösemittel wie 1,1,1-Trichlorethan, Methylenchlorid, Trichlormethan, Perchlorethylen, Toluol besonders gut geeignet. Erfindungsgemäße Aktivierungssysteme, die noch zusätzlich hydrolysierbare metallorganische Verbindungen des Titans, Aluminiums, Zirkons, Siliziums oder Tantals in Mengen von 0,1-20 vorzugsweise 0,1-3 besonders bevorzugt 0,1-2 g/l enthalten, werden bevorzugt eingesetzt. In diesem Zusammenhang seien Kieselsäure-tetramethylester, Octamethylcyclotetrasiloxan, Hexamethylcyclotrisiloxan, Ti- oder Al- bzw. Zr-acetylacetonat erwähnt.

Die Entfernung der Lösungsmittel von den benetzten Trägern erfolgt einfach durch Verdampfen oder bei höher siedenden Verbindungen durch Extraktion.

Nach einer bevorzugten Verfahrensvariante werden die Aktivierungsbäder mit einem Fotometer als Detektor überwacht. Dabei soll die Wellenlänge des Filters dem etwaigen Absorptionsmaxima der Lösung entsprechen. Das Meßsignal wird mit einem Kompensationsschreiber aufgezeichnet, im Takt von 0,1 Sek. bis zu mehreren Minuten von einem Taktgeber abgerufen. So können mit Hilfe eines Computers die fehlenden Komponenten (Lösungsmittel, Aktivator) zudosiert werden.

Eine ganz besonders bevorzugte Ausführungsform des erfindungsgemäßen Verfahrens besteht darin, daß die Reduktion im Metallisierungsbad gleich mit dem Reduktionsmittel der stromlosen Metallisierung durchgeführt wird. Diese Ausführung stellt eine bisher nicht mögliche Vereinfachung der stromlosen Metallisierung dar.

Diese Ausführungsform ist ganz besonders für die bevorzugt einzusetzenden aminboranhaltigen Nickelbäder oder formalinhaltige Kupferbäder geeignet.

Als in dem erfindungsgemäßen Verfahren einsetzbare Metallisierungsbäder kommen handelsübliche Bäder von Nickelsalzen, Cobaltsalzen, Kupfersalzen, Gold- und Silbersalzen oder deren Gemische in Betracht.

Für die galvanische Verstärkung kommen folgende Metalle in Frage:
Ni, Co, Cu, Ag, Al, Cr und Au. Bevorzugt ist Cu.

Halbzeuge, d.h. die nach erfindungsgemäßen Verfahren mit einer nahezu monomolekularen Edelmetall-Kronenetherschicht versehenen Basisplatten aus z.B. glas-, aramid-, kohlefasermatten- oder hartpapierverstärkten Kunststoffen sind bisher nicht in der Literatur beschrieben worden und daher ebenfalls Gegenstand der Erfindung.

Bevorzugte Kunststoffe zur Herstellung der Basisplatten sind härtbare Materialien wie z.B. Phenol-, Epoxid-, Melamin- und Polyesterharze.

Die Halbzeugmaterialien zur Herstellung von Leiterplatten weisen überraschenderweise folgende gute Eigenschaften auf:

1. Sie sind im aktivierten Zustand an der Luft gegenüber Feuchtigkeit, Witterungs- und Wärmeeinflüsse stabil.

2. Ihre Aktivatorauflage ist nicht während des Aufbringens bzw. des Entwickelns von Fotoresistauflagen von der Oberfläche entfernbar.

3. Bei der Sensibilisierung bzw. Metallisierung tritt keine Vergiftung der Metallisierungs- oder Sensibilisierungsbäder ein.

Beispiel 1

Eine glasmattenverstärkte Epoxidharzplatte (200 x 200 x 1 mm) wird mit Normlöchern versehen und dann in einem Pd-haltigen Aktivierungsbad auf der Basis von 1,4,7,10,13-Pentaoxacyclododecan bei RT (Raumtemperatur) im Verlaufe von 3 Minuten mit einer Kronenether-Pd-Schicht versehen.

Die Herstellung des o.a. Aktivierungsbades kann wie folgt durchgeführt werden:
1,7 g wäßrige HCl-freie $Na_2PdCl_4$-Lösung (15 Gew.-% Pd-Gehalt) werden mit 1 l $CH_2Cl_2$ (technisch), welches noch zusätzlich 2,5 g 1,4,7,10,13-Pentaoxacyclododecan und 2 g Titansäure-tetrabutylester enthält, bei RT versetzt, 10 Minuten nachgerührt, bevor die wäßrige Phase von der organischen Phase abgetrennt wird.

Das so hergestellte Halbzeug wird mit einer partiellen Maske (Siebdruckverfahren) versehen, in einem wäßrigen Sensibilisierungsbad bestehend aus 15 g/l Dimethylaminboran, 5 g/l KOH fest im Verlaufe von 5 Minuten sensibilisiert, gewaschen und dann in einem handelsüblichen Metallisierungsbad partiell verkupfert.

Man erhält eine nach dem Volladditivverfahren hergestellte Leiterplatte mit einer sehr guten Metallhaftfestigkeit.

Beispiel 2

15 g methanolische $K_2PtCl_6$-Lösung (Pt-Gehalt etwa 1,75 Gew.-%) werden mit 1 l 1,1,1-Trichlorethan, welches noch zusätzlich 3,5 g polymere Kronenetherverbindung der Formel

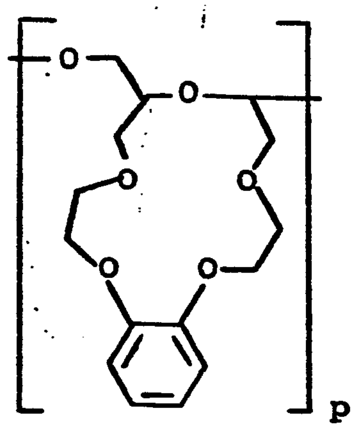

$\bar{p} \sim 10$

(siehe beispielsweise Makromol. Chem., Rapid Commun. 5. 115-118 (1984)) enthält bei 45°C versetzt und dann 30 Minuten nachgerührt. Anschließend wird die wäßrige Phase von der organischen abgetrennt und der organischen Phase 1,3 g Orthotitansäuretetraisopropylester zugesetzt.

Man erhält eine dunkelgefärbte homogene Aktivierungslösung. Mit dieser Lösung werden glasmattenverstärkte Epoxidharzplatten (200 x 200 x 2 mm) 5 Minuten behandelt. Die so aktivierte, d.h. mit einer nahezu monomolekularen, organometallischen Pt-Kronenether-Auflage versehene Platte wird in einem Sensibilisierungsbad, welches pro Liter 20 mltr. $NH_2$-$NH_2$, 12 mltr. $NH_3$ (25 %ig) enthält 7,5 Minuten sensibilisiert und dann in einem handelsüblichen Vernickelungsbad bei 30°C 30 Minuten metallisiert. Man bekommt ein Halbzeug, welches sich nach einer

partiellen Maskierung mit einem handelsüblichen Photolack nach galvanischer Verstärkung der freien Bahnen und anschließender Befreiung der Plattenoberfläche vom Photolack bzw. von der darunter befindlichen Ni-Auflage zu einer Leiterplatte verarbeiten läßt.

Die Abzugsfestigkeit der partiellen Metallauflage (Leiterbahnen) ist gut. Aus elektrischen Untersuchungen geht hervor, daß die guten elektrischen Eigenschaften des Basismaterials von den aufgeführten Behandlungen nicht beeinflußt werden.

Beispiel 3

15 g wäßrige $HAuCl_4$-Lösung (Au-Gehalt 1,8 Gew.-%) werden mit 1 l $CH_2Cl_2$ (technisch), welches noch zusätzlich 3,5 g Kronenether der Formel

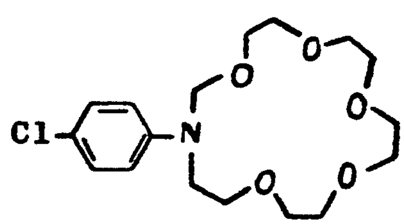

enthält, bei 35°C versetzt und 40 Minuten nachgerührt. Dann wird die wäßrige Phase von der organischen abgetrennt und die organische Phase mit 12 ml Kieselsäuretetramethylester versetzt.

Eine hartpapierverstärkte Phenolharzplatte (200 x 200 x 1,5 mm) wird in 5 Minuten bei RT behandelt.

Die so mit dem Au-Kronenether/Si versehene Halbzeugplatte läßt sich problemlos sowohl nach Semi-Additiv als auch nach Volladditiv-Verfahren zu Leiterplatten (FR-2 Qualität) verarbeiten.

Beispiel 4

Eine handelsübliche glasmattenverstärkte Epoxidharzplatte (200 x 40 x 1 mm) (FR-4 Qualität) wird in einer Lösung bestehend aus 0,01 mol 1,4,7,10,13,16-Hexaoxacyclooctadecan $Na_2PdCl_4$-Komplexverbindung, 2,5 g Titansäuretetrabutylester und 1000 ml $CCl_2=CCl_2$ 5 Min. behandelt.

Man erhält eine Halbzeugplatte mit einer nahezu monomolekularen Pd-Kronenetherschicht.

Die so hergestellte Platte wird in einem handelsüblichen Cu-Bad bei 70°C mit einer 1,0 µm starken Cu-Auflage versehen mit einem handelsüblichen UV-härtbaren Siebdrucklack mit einer Maske, welche freie kammförmige durchgehende Bahnen von etwa 500 µm aufweist, bedeckt und dann mit galvanischem Nickel auf 40 µm verstärkt.

Beispiel 5

Eine aramidfaserverstärkte Epoxidharzplatte (150 x 150 x 2 mm) wird in einer Lösung bestehend aus 1 ltr. $CCl_3$-$CH_3$ und 0,01 Mole 1,4,7,10,13,16-Hexaoxacyclooctadecan-Lithium-tetrachloropalladat im Verlaufe von 5 Min. bei RT mit einer Pd-Kronenetherschicht versehen. Man erhält ein auf chemischem Wege metallisierbares Halbzeug, welches sich hervorragend zur Herstellung von Leiterplatten mit dem guten FR-4 Eigenschaftsprofil sowohl nach der Semiadditiv- als auch nach der Volladditivtechnik eignet.

Beispiel 6

Eine glasfaserverstärkte, handelsübliche ungesättigte Polyesterharzplatte wird in einer Lösung bestehend aus 2,3 g 1,4,7,10,13,16-Hexaoxacyclooctadecan-Hexachloroplatinsäure, 2 g Aluminiumacetylacetonat in 1 ltr. $CH_2Cl_2$ im Verlaufe von 60 Sekunden aktiviert.

Man erhält ein platinisiertes Halbzeug, welches sich gemäß Beispiel 1 gut metallisieren läßt und zur Herstellung von elektrischen Leiterplatten geeignet ist.

Herstellung von 1,4,7,10,13,16-Hexaoxacyclooctadecan-Hexachloroplatinsäure:

6,5 g $H_2PtCl_6$-Lösung (mit 0,01 Mol Pt-Gehalt) werden mit 12 ml n-Propanol, welcher noch zusätzlich 5,284 g 1,4,7,10,13,16-Hexaoxacyclooctadecan enthält versetzt, bei 35°C 4 h gerührt, die Lösung warm abfiltriert, unter Vakuum auf 50 ml eingeengt und dann über Nacht im Kühlschrank gelassen, den so synthetisierten Niederschlag abfiltriert, mit kaltem, nachgereinigtem n-Propanol gewaschen und unter Vakuum getrocknet.

Man erhält eine kristalline kanariengelbe Pt-Kronenetherverbindung mit dem Zersetzungspunkt bei 158°C.

Patentansprüche

1. Halbzeuge zur Herstellung von Leiterplatten bestehend im wesentlichen aus einem Basisträger und einer darauf aufgebrachten, für die stromlose Metallisierung aktivierend wirkenden Metallkomplexverbindung, dadurch gekennzeichnet, daß in dieser Komplexverbindung die Liganden und die zu komplexierenden Ionen bzw. Moleküle in einer "Wirt/Gast-Wechselwirkung" zueinander stehen.

2. Halbzeuge nach Anspruch 1, dadurch gekennzeichnet, daß die komplexbildungsfähigen Wirtsmoleküle in den metallorganischen Verbindungen Kronenether, Cryptanden oder Podanden sind.

3. Halbzeuge nach Anspruch 1, dadurch gekennzeichnet, daß der Komplexligand bzw. das Wirtsmolekül eine cyclische Verbindung ist, welche in Gegenwart des zu komplexierenden Mediums die zur Komplexbildung bzw. Wirt/Gast-Wechselwirkung erforderlichen Struktur annimmt.

4. Verfahren nach Anspruch 1, dadurch gekennzeichnet, daß die Wirtsmoleküle cyclische Kronenether der Formeln

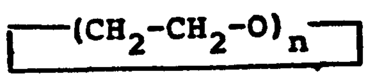

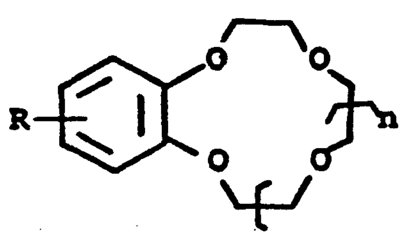

n = 0-4

R = Alkyl, Aryl, Halogen u.a.

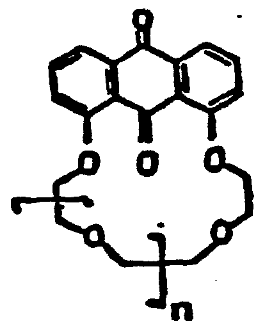

(III)

n = 0-4

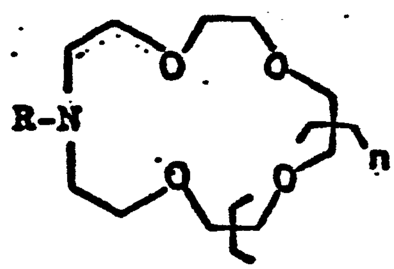

(IV)

n = 0-4

R = Alkyl oder Aryl; z.B. Methyl, Ethyl, Phenyl, Biphenyl, Phenylazophenyl u.a.

5. Halbzeuge nach Anspruch 1, dadurch gekennzeichnet, daß der selektive Komplexligand bzw. das Wirtsmolekül in den metallorganischen Verbindungen ein reines Kohlenwasserstoffgerüst, das durch O-Atome unterbrochen ist, aufweisen.

6. Halbzeug nach Anspruch 1, dadurch gekennzeichnet, daß das zu komplexierende Medium in den Wirt/Gast-Molekülen eine Verbindung der Formel

$$\left[ Me^{n+}\ E^{m+}\ Hal_z \right]$$

ist, worin Me für Wasserstoff-, Alkali-, Erdalkali- oder Schwermetallatome, oder für $NH_4$, Hal für Halogen, E für ein Edelmetallatom der 1. und 8. Nebengruppe des Periodensystems, mit der Wertigkeit m und der Koordinationszahl z steht, wobei z-m=n ist.

7. Halbzeuge nach Anspruch 1, dadurch gekennzeichnet, daß die zu komplexierende Gastmolekel eine Verbindung aus der Reihe $H_2PdCl_4$, $Na_2(PdCl_2Br_2)$, $Na_2PdCl_4$, $CaPdCl_4$, $Na_4(PtCl_6)$, $AgNO_3$, CuCl und $CuCl_2$ ist.

8. Halbzeuge nach Anspruch 1, dadurch gekennzeichnet, daß die Basisträger aus gegebenenfalls faserverstärkten Phenol-, Melamin-, Epoxid- oder Polyesterharzen, bestehen.

9. Verfahren zur Herstellung von Halbzeugen zur Herstellung von Leiterplatten durch Behandlung von Basisträgern mit Aktivatorsystemen auf der Basis von Metallkomplexverbindungen für die stromlose

Metallisierung, dadurch gekennzeichnet, daß in den Metallkomplexverbindungen die Liganden und die zu komplexierenden Ionen bzw. Moleküle in einer "Wirts/Gast-Wechselbeziehung" zueinander stehen.